# EUROPEAN PATENT SPECIFICATION

(11) **EP 0 209 654 B1**
(45) Date of publication and mention of the grant of the patent: **14.12.1994**
(21) Application number: 86106245.3
(22) Date of filing: 07.05.1986
(51) Int. Cl.: H01L 29/40, H01L 23/485, H01L 29/54

(54) **Semiconductor device having wiring electrodes**
Halbleiteranordnung mit Verbindungselektroden
Dispositif semi-conducteur comprenant des électrodes d'interconnexion

(30) Priority: 13.05.1985 JP 100915/85; 05.09.1985 JP 196503/85
(43) Date of publication of application: 28.01.1987
(60) Divisional application: 94108007.9
(73) Proprietor: KABUSHIKI KAISHA TOSHIBA, Kawasaki-shi, Kanagawa-ken 210 (JP)
(72) Inventor: Maeda, Takeo c/o Patent Division, Minato-ku Tokyo 105 (JP)
(74) Representative: Lehn, Werner, Dipl.-Ing.

(56) References cited:
- PATENT ABSTRACTS OF JAPAN, vol. 7, no. 204 (E-197)[1349], 9th September 1983 & JP-A-58-101 454
- IBM TECHNICAL DISCLOSURE BULLETIN, vol. 25, no. 12, May 1983, pages 6398-6399, New York, US; C.Y. TING: "New structure for contact metallurgy"
- IBM TECHNICAL DISCLOSURE BULLETIN, vol. 15, no. 10, March 1973, pages 3027-3028, New York, US; H.M. DALAL et al.: "Multilevel interconnection metallurgy system for semiconductor devices"
- JOURNAL OF VACUUM SCIENCE & TECHNOLOGY A, vol. 3, no. 6, November/December 1985, pages 2233-2236, American Vacuum Society, Woodbury, New York, US; I. SUNI et al.: "Performance of titanium nitride diffusion barriers in aluminum-titanium metallization schemes for integrated circuits"
- Thin Solid Films, vol 52 (1978), pages 415-443

## Description

### SEMICONDUCTOR DEVICE HAVING WIRING ELECTRODES

The present invention relates to a semiconductor device comprising: a semiconductor element; an insulating film formed on said semiconductor element, said insulating film having a contact hole exposing a portion of said semiconductor element; and a wiring electrode connected to said semiconductor element through said contact hole, said wiring electrode being composed of a first layer of Ti formed on said insulating film and the exposed portion of said semiconductor element, a second layer of TiN formed on said first layer, and a third layer having Al as its major component and formed on said second layer.

Such a device is known from JP-A-58-101454. The invention also relates to a method of manufacturing such a semiconductor device.

In semiconductor devices such as MOS transistors, aluminium is used as a wiring layer. A MOS transistor has, for example, n-type diffusion regions in the surface area of a p-type silicon substrate. These regions are used as a source and drain. Contact holes are formed by patterning an insulating layer covering the substrate and diffusion layers. In connecting the wiring layer with the diffusion layer, Al is deposited on the diffusion layer by sputtering, and alloyed with Si by annealing.

However, when the wiring layer is heated to a temperature of 450°C in another step, the Al diffuses from the wiring layer into the silicon substrate, growin Al-Si spikes within the substrate. In recent years shallow diffusion layers are often formed with a use of BF₂ and BCl₂, and, in this case, the alloy spikes may grow deeper than the diffusion layer. If spikes penetrate the diffusion layer and reach the substrate, the pn junction between the substrate and the diffusion layer will break down.

Furthermore, disconnection of the wiring layer occurs easily in the portion inside of the contact hole. This is because electromigration occurs in this portion when a relatively large current flows in the Al wiring layer.

Two conventional methods of preventing alloy spikes are known. In the first method, Al is deposited by sputtering, together with about 1 to 5% of Si (based on Al amount), onto the diffusion layer. This method can reliably prevent alloy spikes. However, it would only be used when an increase in contact resistance can be ignored. In practice, such an increase in contact resistance cannot be ignored, and the Si amount must be reduced to a low percentage at which alloy spikes can not be sufficiently prevented. Namely, a high amount of silicon is preferable in the control of alloy spike growth. If the Si amount exceeds the solid solubility of Al, however, solid Si precipitates in the wiring layer in addition to the Al-Si alloy. The precipitated Si has a remarkably low conductivity. The contact resistance of the wiring layer undesirably increases due to the low conductivity. In particular, the narrow region of the wiring layer inside of the contact hole may be electrically separated from the diffusion region due to the precipitated Si. In addition, Al and Si may not always be deposited at a uniform ratio during sputtering. As a result, even if the Si amount is within the solid solubility of Al, Si will precipitate in a portion of the wiring layer.

In the second conventional method, a barrier metal layer, such as a TiN layer, is formed between the diffusion layer and the Al layer. When the barrier metal is TiN, the boron (B) contained in the diffusion layer diffuses into the TiN layer, making it impossible to obtain good ohmic contact.

In the second conventional method, a barrier metal layer, such as a TiN layer, is formed between the diffusion layer and the metal layer. When the barrier metal is TiN, the boron (B) contained in the diffusion layer diffuses into the TiN layer, making it impossible to obtain good ohmic contact.

It is an object of the present invention to provide a semiconductor device which prevents alloy spikes without increasing the contact resistance of a wiring layer and offers good resistance against electromigraion.

According to one aspect of the invention, the device initially defined is characterized in that said wiring electrode further comprises a fourth layer of Ti formed between said second layer and said third layer.

According to another aspect of the invention, there is provided a method for manufacturing a semiconductor device, said method comprising the steps of:
forming an insulating film covering a surface of a silicon substrate;
forming a semiconductor element in the surface of said silicon substrate;
patterning said insulating film to form a contact hole exposing a portion of said semiconductor element;
depositing Ti on said insulating film and the exposed portion of said semiconductor element to form a first layer; and
depositing TiN on said first layer to form a second layer;
depositing Ti on said second layer to form a third layer; and
depositing a material having A1 as its major component on said third layer to form a fourth layer;
said first to fourth layers forming a wiring electrode.

For a better understanding of the invention, and to show how the same may be carried into effect, reference will now be made, by way of example, to the accompanying drawings, in which:
Figs. 1A to 1F show steps in the manufacture of a CMOS transistor;
Fig. 2 is a graph for explaining the relationship between contact resistance and contact hole size;
Figs. 3A and 3B are diagrams for explaining steps in the manfuacture of a CMOS transistor;
Fig. 4 shows a CMOS transistor having a Ti layer according to the present invention; and
Fig. 5 shows a CMOS transistor having a TiSi layer.

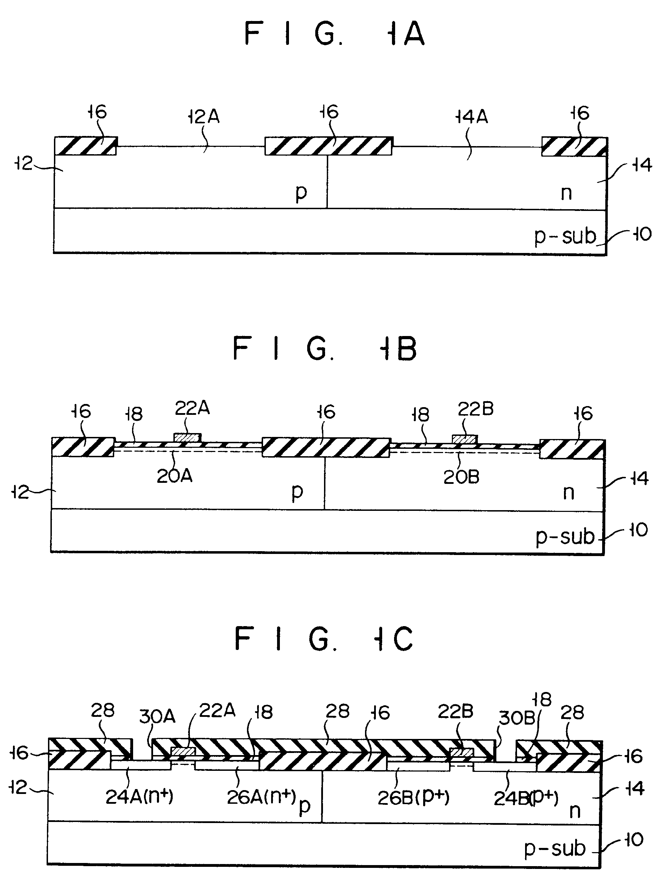

The semiconductor devices shown in Figs. 1 to 3 and 5 are not in accordance with the present invention.

### Detailed Description

A first semiconductor device will be described with reference to Figs. 1A to 1F. Figs. 1A to 1F show steps in the manufacture of a CMOS transistor. In the first step, p-type silicon substrate 10 is prepared. p-type well 12 and n-type well 14 are formed in the surface area of substrate 10, as shown in Fig. 1A. Field oxide film 16 is formed to surround portions 12A and 14A of wells 12 and 14, which serve as element regions, as shown in Fig. 1A. The surfaces of element regions 12A and 14A are completely covered by gate oxide film 18, as shown in Fig. 1B. Channel implantation processing is then performed to set the threshold voltage of the transistor. This results in the formation of ion implantation layers 20A and 20B in regions 12A and 14A. A polycrystalline silicon layer (not shown) is formed on films 16 and -18 by deposition, doped with a predetermined amount of an impurity, and patterned. The remaining polycrystalline silicon constitutes gate electrodes 22A and 22B, as shown in Fig. 1B. An n-type impurity (e.g., P or As) and a p-type impurity (e.g., B, BF₂, or BCℓ₂) are ion-implanted in wells 12 and 14 in separate steps, using electrodes 22A and 22B as masks. Substrate 10 is then annealed, forming n⁺-type source and drain regions 24A and 26A in the surface area of well 12, and forming p⁺-type source and drain regions 24B and 26B in the surface area of well 14, as shown in Fig. 1C. Films 16 and 18 and electrodes 22A and 22B are covered by interlayer insulating film 28. Films 28 and 18 are patterned to form contact holes 30A and 30B, as shown in Fig. 1C. Contact holes 30A and 30B expose the corresponding portions of regions 24A and 24B.

Ti layer 32 and TiN layer 34 shown in Fig. 10 are successively formed in the same vacuum chamber by sputtering. In this step, Ti is deposited to a thickness of 50 nm on film 28 and on the exposed surfaces of source regions 24A and 24B. TiN is then deposited to a thickness of 50 nm on top of the Ti. An RF bias is applied to substrate 10 during the deposition of TiN to provide good crystallinity in the portion of contact between Ti layer 32 and TiN layer 34 and good step coverage. After layer 34 is formed, pure aluminum is deposited on layer 34 in the same vacuum chamber, forming Aℓ layer 36, as shown in Fig. 1D. The multi-layer structure of layers 36, 34, and 32 is patterned by photoetching and reactive ion etching, as shown in Fig. 1E. Remaining structures 38A and 38B are used as wiring electrodes for source regions 24A and 24B. In the patterning step, a gas mixture of BCℓ₃, Cℓ₂ and He is used as the etchant. Wiring electrodes 38A and 38B and film 28 are completely covered by SiO₂ layer 40. Layer 40 is formed by a low-temperature plasma CVD method, and is patterned to form contact hole 42 on layer 36, as shown in Fig. 1F. Aℓ layer 44, also shown in Fig. 1F, is formed by the same method and connected to layer 36. This completes the preparation of a CMOS transistor. In this transistor, electrodes 38A and 38B are used as a first-stage wiring layer, and layer 44 is used as a second-stage wiring layer. In this semiconductor device, wiring of the drain and control gate is formed just as described above, and has hence been omitted for the sake of brevity.

In the semiconductor device described above, Ti and TiN layers 32 and 34 are provided between Aℓ layer 36 and source regions 24A and 24B. TiN layer 34 acts as a barrier metal to block Aℓ diffusion along grain boundaries in Aℓ layer 36, thus preventing the growth of alloy spikes. As a result, the pn junctions between source region 24A and well 12 and between source region 24B and well 14 do not break down. Ti layer 32, in addition to preventing the boron in p⁺-type source region 24B from diffusing into layer 34, also maintains a low contact resistance between electrodes 38A and 38B and corresponding regions 24A and 24B. Ti and TiN layers 32 and 34, having high resistance to electromigration, will constitute a current path even if Aℓ layer 36 disappears due to electromigration. As a result, a complete failure in transistor functions cannot occur. Since TiN layer 34 has a thickness sufficient to prevent the growth of alloy spikes, Aℓ layer 36 need not contain Si. Thus, silicon does not precipitate in electrodes 38A and 38B, and the problem caused by Si precipitation in the portions of electrodes 38A and 38B inside of the contact holes can be avoided.

An experiment verified that good contact characteristics are obtained between electrode 38A and source region 24A and between electrode 38B and source region 24B. In this experiment, Ti layer 32 was sintered at 450°C for 15 minutes, and contact resistance was measured. The Ti was satisfactorily changed into TiSi by the sintering process, demonstrating that good contact characteristics can be obtained.

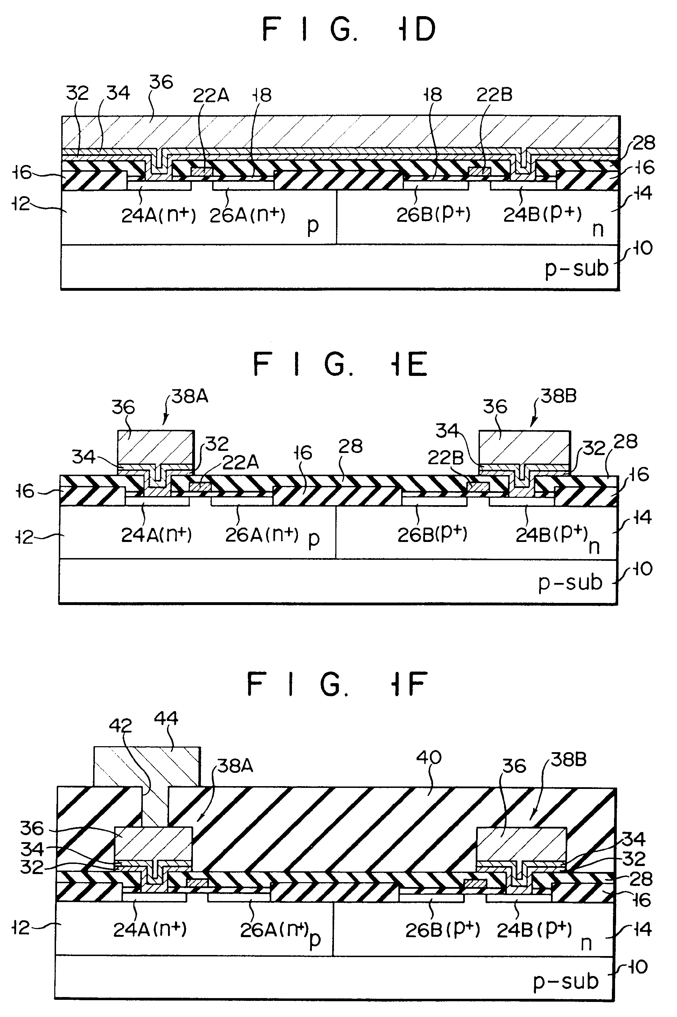

Fig. 2 shows the relationship between contact resistance and contact hole size. Curves (A) and (B) in Fig. 2 show the case where TiN is connected by a conventional technique to p⁺-type and n⁺-type silicon, respectively. Curves (C) and (D) show the case where Ti is connected to p⁺-type and n⁺-type silicon, respectively, according to the semiconductor device described above. As can be seen from the graph, there is no drastic increase in contact resistance with the above described first semiconductor devices, even when contact hole size is reduced. Ti and p⁺-type silicon (i.e., Ti layer 32 and source region 24B) particularly experience larger reductions in contact resistance than in the conventional method.

In the above first semiconductor device, pure aluminum layer 36 is used. The layer 36 can be replaced by one alloy selected from Aℓ-Si, Aℓ-Ti-Si, Aℓ-Zr-Si, Aℓ-Ti, and Aℓ-Zr. When an alloy layer containing Ti or Zr is used, Aℓ electromigration and Aℓ hillocks are prevented. When an alloy layer containing Si is used, the resistance of the alloy layer and the boron-doped diffusion layer are sufficiently kept low. In addition, openings in the wiring are prevented.

It is also possible to change the manufacturing steps for the CMOS transistor described above in the following manner. After forming layers 32 and 34 with sputtering in the same vacuum chamber, as shown in Fig. 1D, the semiconductor structure is annealed at 600°C for 30 minutes in a nitrogen atmosphere. This insures the complete transformation to TiN of the Ti grains in layer 34.

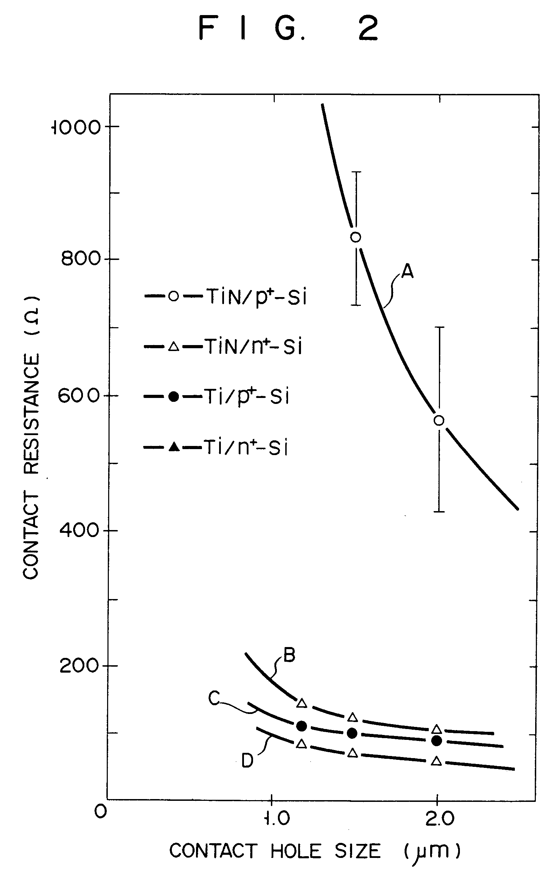

After annealing, Aℓ-Si alloy layer 37 is formed on layer 34, as shown in Fig. 3A. Argon (Ar), for example, is then ion-implanted in the surface area of layer 37 at a dose of 5 x 10¹⁵ cm⁻² and an acceleration voltage of 30 keV. This causes the portion of layer 37 as extending to the dashed line (Fig. 3B) to become amorphous. The remaining steps are the same as the steps above described.

When TiN layer 34 is annealed in a nitrogen atmosphere as described above, Ti in layer 34 becomes a nitride. This serves to control so that an Aℓ-Si-Ti three-element alloy is not formed. Aℓ-Si alloy layer 37 prevents alloy spikes, even if layer 34 has pinholes. Furthermore, since the surface crystal of layer 37 is broken through the Ar ion-implantation, the Aℓ in layer 37 does not migrate along grain boundaries during the formation of layer 44. Thus, the generation of hillocks, electromigration, and thermal migration are prevented. With the device, the wiring is hardly be disconnected along Aℓ grain boundaries. The amorphous portion of layer 37 absorbs stress when the layer 44 is formed.

In addition, layer 37 may be replaced with Al layer 36.

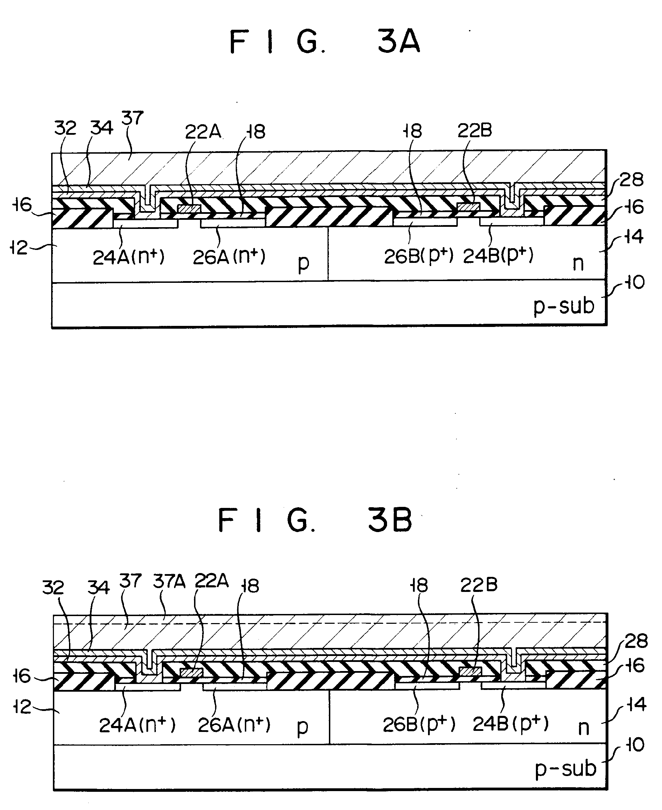

In Figs. 3A and 3B above, wiring electrodes 38A and 38B have a 3-layer structure of Al alloy layer 37 (or Al layer 36), TiN layer 34, and Ti layer 32. The electrodes may also have a Ti layer 50 between layers 37 and 34, as shown in Fig. 4. With this structure, the Ti layer 50 prevents the diffusion of N from TiN layer 34 into Al alloy layer 37 (or Al layer 36). Ti diffuses from the Ti layer into layer 37 (or layer 36), thus preventing Al hillocks.

In the above semiconductor devices, Ar was ion-implanted in layer 37. It is also possible, however, to ion-implant As, BF₂, or a mixture of the two.

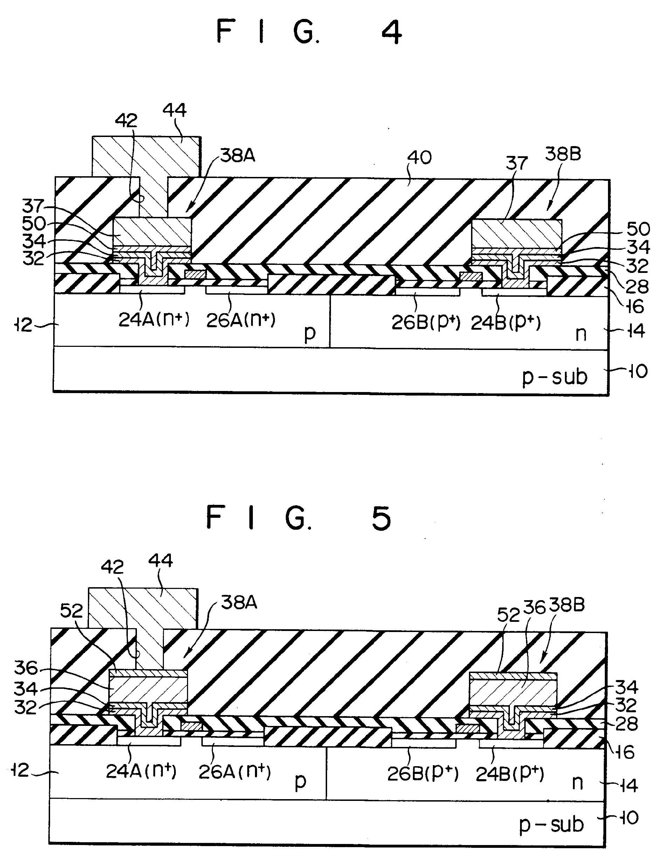

In the first semiconductor device described above, wiring electrodes 38A and 38B have a 3-layer structure formed of Al, TiN and Ti layers 36,34 and 32. However, the electrodes 38A, 38B may have a 4-layer structure in which a TiSi layer 52 is further formed on top of Al layer 36 as shown in Fig. 5. The TiSi layer 52 blocks Al hillocks with the stress corresponding to their growth and allows diffusion of Ti into the Al or Al alloy layer, thereby preventing hillocks. This Ti also plays a large role in the control of electromigration. In the manufacture of the 4-layer structure, the Ti, TiN, Al, and TiSi layers can all be deposited in the same vacuum.

In the described devices, the first and second layers are provided between the third layer and semiconductor element. The second layer acts as a barrier metal to block Al diffusion along grain boundaries in the third layer, thus preventing occurence of alloy spikes. The first layer maintains a low contact resistance between the wiring layer and the semiconductor element. The first and second layers, having high resistance to electromigration, will constitute a current path even if the third layer disappears due to electromigration.

## Claims

1. A semiconductor device comprising:
a semiconductor element (24A);
an insulating film (16, 18, 28) formed on said semiconductor element (24A), said insulating film (16, 18, 28) having a contact hole (30A) exposing a portion of said semiconductor element (24A); and
a wiring electrode (38A) connected to said semiconductor element (24A) through said contact hole (30A), said wiring electrode (38A) being composed of a first layer (32) of Ti formed on said insulating film (16, 18, 28) and the exposed portion of said semiconductor element (24A), a second layer (34) of TiN formed on said first layer (32), and a third layer (37) having Al as its major component and formed on said second layer (34);
characterized in that
said wiring electrode further comprises a fourth layer (50) of Ti formed between said second layer (34) and said third layer (37).

2. A device according to claim 1, characterized in that said third layer (37) is made of one member selected from the group consisting of pure Al, an Al-Si alloy, an Al-Ti-Si alloy, an Al-Zr-Si alloy, an Al-Ti alloy and an Al-Zr alloy.

3. A device according to any preceding claim, characterized in that said wiring electrode further comprises a layer (52) of TiSi formed on said third layer (37).

4. A device according to any preceding claim, characterized in that said semiconductor element is a diffusion region of a first conductivity type formed in a semiconductor substrate (10) of a second conductivity type.

5. A device according to claim 4, characterized in that said third layer (37) has an amorphous surface region having at least one implanted impurity selected from the group consisting of As, BF₂ and Ar.

6. A device according to claim 5, characterized by further comprising:
a second insulating film (40) formed on said wiring electrode (38A) and having a second contact hole (42) exposing a portion of the amorphous surface region of said third layer (37); and
a wiring layer (44) formed on said second insulating film (40) and contacting the exposed portion of said third layer (37) through said second contact hole (42).

7. A device according to any preceding claim, characterized in that said third layer (37) has an amorphous surface region having at least one implanted impurity selected from the group consisting of As, BF₂ and Ar.

8. A device according to claim 1, characterized by further comprising:
a second insulating film (40) formed on said wiring electrode (38A) and having a second contact hole (42) exposing a portion of a surface region of said third layer (37); and
a wiring layer (44) formed on said second insulating film (40) in contact with the surface region of said third layer (37) through said second contact hole (42).

9. A method of manufacturing a semiconductor device with a wiring electrode, said method comprising the steps of:
forming an insulating film (16, 18, 28) covering a surface of a silicon substrate (10);
forming a semiconductor element (24A) in the surface of said silicon substrate (10);
patterning said insulating film (16, 18, 28) to form a contact hole (30A) exposing a portion of said semiconductor element (24A);
depositing Ti on said insulating film (16, 18, 28) and the exposed portion of said semiconductor element (24A) to form a first layer (32); and
depositing TiN on said first layer (32) to form a second layer (34);
depositing Ti on said second layer (34) to form a third layer (50); and
depositing a material having Al as its major component on said third layer (50) to form a fourth layer (37);
said first to fourth layers (32, 34, 50, 37) forming said wiring electrode.

10. A method according to claim 9, characterized by further comprising the step of patterning said first to fourth layers (32, 34,50, 37) so that the remaining portions of said first to fourth layers (32, 34, 50, 37) serve as a wiring layer.

11. A method according to claim 10, characterized by further comprising the step of forming an insulative, protective film (40) covering said wiring layer and the exposed portion of said insulating layer (16, 18, 28) by low-temperature plasma chemical vapor deposition.

12. A method according to claim 11, characterized in that said insulating layer (16, 18, 28) and said insulative, protective film (40) are composed of silicon oxide.

13. A method according to any of claims 9 to 12, characterized in that said semiconductor element (24A) is formed by doping an impurity in the surface of said silicon substrate (10).

14. A method according to claim 13, characterized in that said semiconductor element (24A) contains a p-type impurity.

15. A method according to any of claims 9 to 14, characterized in that said fourth layer (37) is formed of a material selected from the group consisting of pure Al, Al-Si alloys, Al-Ti-Si alloys, Al-Zr-Si alloys, Al-Ti alloys, and Al-Zr alloys.

16. A method according to any of claims 9 to 15, characterized by further comprising the step of subjecting a surface of said fourth layer (37) to ion implantation of at least one impurity selected from the group consisting of As, BF₂ and Ar so that the surface of said fourth layer (37) becomes amorphous.

17. A method according to claim 9, characterized by further comprising a step of annealing said second layer (34) in a nitrogen atmosphere.

## Patentansprüche

1. Halbleitervorrichtung, aufweisend:
- ein Halbleiterelement (24A);
- einen Isolierfilm (16, 18, 28), der auf dem Halbleiterelement (24A) gebildet ist, wobei der Isolierfilm (16, 18, 28) ein Kontaktloch (30A) aufweist, das einen Abschnitt des Halbleiterelementes (24A) exponiert; und
- eine Verdrahtungselektrode (28A), die durch das Kontaktloch (30A) mit dem Halbleiterelement (24A) verbunden ist, wobei die Verdrahtungselektrode (38A) aus einer ersten Schicht (32) aus Ti, das auf dem Isolierfilm (16, 18, 28) und dem exponierten Abschnitt des Halbleiterelementes (24A) gebildet ist, einer zweiten Schicht (34) aus TiN, das auf der ersten Schicht (32) gebildet ist, und einer dritten Schicht (37), mit Aℓ als ihrer Hauptkomponente, gebildet und auf der zweiten Halbleiterschicht (34) hergestellt ist;
dadurch **gekennzeichnet**, daß
die Verdrahtungselektrode weiter eine vierte Schicht (50) aus Ti umfaßt, die zwischen der zweiten Schicht (34) und der dritten Schicht (37) gebildet ist.

2. Vorrichtung nach Anspruch 1,
dadurch **gekennzeichnet**, daß die dritte Schicht (37) aus einer Komponente gebildet ist, die aus der Gruppe, bestehend aus reinem Aℓ, einer Aℓ-Si-Legierung, einer Aℓ-Ti-Si-Legierung, einer Aℓ-Zr-Si-Legierung, einer Aℓ-Ti-Legierung und einer Aℓ-Zr-Legierung gewählt ist.

3. Vorrichtung nach Anspruch 1 oder 2,
dadurch **gekennzeichnet**, daß die Verdrahtungselektrode weiter eine Schicht (52) aus TiSi umfaßt, die auf der dritten Schicht (37) gebildet ist.

4. Vorrichtung nach irgendeinem vorhergehenden Anspruch,
dadurch **gekennzeichnet**, daß das Halbleiterelement ein Diffusionsbereich eines ersten Leitfähigkeitstyps ist, der in einem Halbleitersubstrat (10) eines zweiten Leitfähigkeitstyps gebildet ist.

5. Vorrichtung nach Anspruch 4,
dadurch **gekennzeichnet**, daß die dritte Schicht (37) einen amorphen Oberflächenbereich aufweist, der mindestens ein implantiertes Fremdatom enthält, die aus der Gruppe, bestehend aus Aℓ, Bf₂ und Ar gewählt ist.

6. Vorrichtung nach Anspruch 5,
dadurch **gekennzeichnet**, daß sie weiter aufweist:
- einen zweiten Isolierfilm (40), der auf der Verdrahtungselektrode (38A) gebildet ist und ein zweites Kontaktloch (42) aufweist, das einen Abschnitt des amorphen Oberflächenbereichs der dritten Schicht (37) exponiert; und
- eine Verdrahtungsschicht (44), die auf dem zweiten Isolierfilm (40) gebildet ist und den exponierten Abschnitt der dritten Schicht (37) durch das zweite Kontaktloch (42) kontaktiert.

7. Vorrichtung nach irgendeinem vorhergehenden Anspruch, dadurch **gekennzeichnet**, daß die dritte Schicht (37) einen amorphen Oberflächenbereich aufweist, der mindestens ein implantiertes Fremdatom enthält, die aus der Gruppe, bestehend aus As, BF₂ und Ar gewählt ist.

8. Vorrichtung nach Anspruch 1,
dadurch **gekennzeichnet**, daß sie weiter aufweist:
- einen zweiten Isolierfilm (40), der auf der Verdrahtungselektrode (38A) gebildet ist und ein zweites Kontaktloch (42) aufweist, das einen Abschnitt des amorphen Oberflächenbereichs der dritten Schicht (37) exponiert; und
- eine Verdrahtungsschicht (44), die auf dem zweiten Isolierfilm (40) gebildet ist und den exponierten Abschnitt der dritten Schicht (37) durch das zweite Kontaktloch (42) kontaktiert.

9. Verfahren zum Herstellen einer Halbleitervorrichtung, wobei das Verfahren folgende Schritte aufweist:
- Bilden eines Isolierfilms (16, 18, 28), der eine Oberfläche eines Siliciumsubstrats (10) bedeckt;
- Bilden eines Halbleiterelementes (24A) in der Oberfläche des Siliciumsubstrats (10);
- Mustern des Isolierfilms (16, 18, 28), um ein Kontaktloch (30A) zu bilden, das einen Abschnitt des Halbleiterelementes (24A) exponiert;
- Aufbringen von Ti auf dem Isolierfilm (16, 18, 29) und dem exponierten Abschnitt des Halbleiterelementes (24A), um eine erste Schicht (32) zu bilden; und
- Aufbringen von TiN auf der ersten Schicht (32), um eine zweite Schicht (34) zu bilden;
dadurch **gekennzeichnet**, daß das Verfahren weiter folgende Schritte aufweist:
- Aufbringen von Ti auf der zweiten Schicht (34), um eine dritte Schicht (50) zu bilden; und
- Aufbringen eines Aℓ enthaltenden Materials auf der dritten Schicht (50), um eine vierte Schicht (37) zu bilden.

10. Verfahren nach Anspruch 9,
dadurch **gekennzeichnet**, daß es weiter den Schritt der Musterung der ersten bis vierten Schicht (32, 34, 50, 37) umfaßt, so daß die verbleibenden Abschnitte der ersten bis vierten Schicht (32, 34, 50, 37) als Verdrahtungsschicht dienen.

11. Verfahren nach Anspruch 10,
dadurch **gekennzeichnet**, daß es weiter den Schritt der Bildung eines isolierenden, schützenden Films (40) durch plasmachemische Abscheidung aus der Gasphase umfaßt, welche die Verdrahtungsschicht und den exponierten Abschnitt der Isolierschicht (16, 18, 28) bedeckt.

12. Verfahren nach Anspruch 11,
dadurch **gekennzeichnet**, daß die Isolierschicht (16, 18, 28) und der isolierende, schützende Film (40) aus Siliciumoxid zusammengesetzt sind.

13. Verfahren nach irgendeinem der Ansprüche 9 bis 12,
dadurch **gekennzeichnet**, daß das Halbleiterelement (24A) durch Dotieren eines Fremdatoms in die Oberfläche des Siliciumsubstrats (10) gebildet ist.

14. Verfahren nach Anspruch 13,
dadurch **gekennzeichnet**, daß das Halbleiterelement (24A) ein P-leitendes Fremdatom enthält.

15. Verfahren nach irgendeinem der Ansprüche 9 bis 14,
dadurch **gekennzeichnet**, daß die vierte Schicht (37) aus einem Material gebildet ist, das aus der Gruppe, bestehend aus reinem Aℓ, Aℓ-Si-Legierungen, Aℓ-Ti-Si-Legierungen, Aℓ-Zr-Si-Legierungen, Aℓ-Ti-Legierungen und Aℓ-Zr-Legierungen, gewählt ist.

16. Verfahren nach irgendeinem der Ansprüche 9 bis 15,
dadurch **gekennzeichnet**, daß es weiter einen Schritt aufweist, der eine Oberfläche der vierten Schicht (37) der Ionenimplantation durch mindestens ein Fremdatom aussetzt, die aus der Gruppe, bestehend aus As, BF₂ und Ar, gewählt ist, so daß die Oberfläche der vierten Schicht (37) amorph wird.

17. Verfahren nach Anspruch 9,
dadurch **gekennzeichnet**, daß es weiter einen Schritt des Glühens der zweiten Schicht (34) in einer Stickstoffatmosphäre aufweist.

## Revendications

1. Dispositif à semi-conducteur comprenant :
un élément semi-conducteur (24A) ;
un film isolant (16, 18, 28) formé sur ledit élément semi-conducteur (24A), ledit film isolant (16, 18, 28) comportant un trou de contact (30A) mettant à nu une partie dudit élément semi-conducteur (24A) ; et
une électrode de câblage (38A) connectée audit élément semi-conducteur (24A) par ledit trou de contact (30A), ladite électrode de câblage (38A) étant composée d'une première couche (32) de Ti formée sur ledit film isolant (16, 18, 28) et sur la partie mise à nu dudit élément semi-conducteur (24A), d'une deuxième couche (34) de TiN formée sur ladite première couche (32), et d'une troisième couche (37) ayant l'Al comme composant principal et formée sur ladite deuxième couche (34) ;
caractérisé en ce que :
ladite électrode de câblage comprend, en outre, une quatrième couche (50) de Ti formée entre ladite deuxième couche (34) et ladite troisième couche (37).

2. Dispositif selon la revendication 1, caractérisé en ce que ladite troisième couche (37) est faite d'un élément choisi dans le groupe constitué de l'Al pur, d'un alliage d'Al-Si, d'un alliage d'Al-Ti-Si, d'un alliage d'Al-Zr-Si, d'un alliage d'Al-Ti, et d'un alliage d'Al-Zr.

3. Dispositif selon l'une quelconque des revendications précédentes, caractérisé en ce que ladite électrode de câblage comprend, en outre, une couche (52) de Ti-Si formée sur ladite troisième couche (37).

4. Dispositif selon l'une quelconque des revendications précédentes, caractérisé en ce que ledit élément semi-conducteur est une région de diffusion d'un premier type de conductivité formée dans un substrat semi-conducteur (10) d'un second type de conductivité.

5. Dispositif selon la revendication 4, caractérisé en ce que ladite troisième couche (37) a une région de surface amorphe ayant au moins une impureté implantée, choisie dans le groupe constitué de l'As, du BF₂ et de l'Ar.

6. Dispositif selon la revendication 5, caractérisé en ce qu'il comprend, en outre :
un second film isolant (40) formé sur ladite électrode de câblage (38A) et ayant un second trou de contact (42) mettant à nu une partie de la région de surface amorphe de ladite troisième couche (37) ; et
une couche de câblage (44) formée sur ledit second film isolant (40) et contactant la partie mise à nu de ladite troisième couche (37) par ledit second trou de contact (42).

7. Dispositif selon l'une quelconque des revendications précédentes, caractérisé en ce que ladite troisième couche (37) a une région de surface amorphe ayant au moins une impureté implantée, choisie dans le groupe constitué de l'As, du BF₂ et de l'Ar.

8. Dispositif selon la revendication 1, caractérisé en ce qu'il comprend, en outre :
un second film isolant (40) formé sur ladite électrode de câblage (38A) et ayant un second trou de contact (42) mettant à nu une partie d'une région de surface de ladite troisième couche (37) ; et
une couche de câblage (44) formée sur ledit second film isolant (40) en contact avec la région de surface de ladite troisième couche (37) par ledit second trou de contact (42).

9. Procédé de fabrication d'un dispositif à semi-conducteur, ledit procédé comprenant les étapes :
de formation d'un film isolant (16, 18, 28) recouvrant une surface d'un substrat de silicium (10) ;
de formation d'un élément semi-conducteur (24A) dans la surface dudit substrat de silicium (10) ;
de dessin dudit film isolant (16, 18, 28) pour former un trou de contact (30A) mettant à nu une partie dudit élément semi-conducteur (24A) ;
de dépôt de Ti sur ledit film isolant (16, 18, 28) et sur la partie mise à nu dudit élément semi-conducteur (24A) pour former une première couche (32) ; et
de dépôt de TiN sur ladite première couche (32) pour former une deuxième couche (34) ;
caractérisé en ce qu'il comprend, en outre, les étapes :
de dépôt de Ti sur ladite deuxième couche (34) pour former une troisième couche (50) ; et
de dépôt d'une matière contenant de l'Al sur ladite troisième couche (50) pour former une quatrième couche (37).

10. Procédé selon la revendication 9, caractérisé en ce qu'il comprend, en outre, l'étape de dessin desdites première à quatrième couches, (32, 34, 50, 37) de telle manière que les parties restantes desdites première à quatrième couches (32, 34, 50, 37) servent de couche de câblage.

11. Procédé selon la revendication 10, caractérisé en ce qu'il comprend, en outre, l'étape de formation d'un film protecteur isolant (40) recouvrant ladite couche de câblage et la partie mise à nu de ladite couche isolante (16, 18, 28) par dépôt chimique en phase vapeur au plasma à basse température.

12. Procédé selon la revendication 11, caractérisé en ce que ladite couche isolante (16, 18, 28) et ledit film protecteur isolant (40) sont composés d'oxyde de silicium.

13. Procédé selon l'une quelconque des revendications 9 à 12, caractérisé en ce que ledit élément semi-conducteur (24A) est formé par dopage d'une impureté dans la surface dudit substrat de silicium (10).

14. Procédé selon la revendication 13, caractérisé en ce que ledit élément semi-conducteur (24A) contient une impureté de type p.

15. Procédé selon l'une quelconque des revendications 9 à 14, caractérisé en ce que ladite quatrième couche (37) est formée d'une matière choisie dans le groupe constitué de l'Al pur, des alliages d'Al-Si, des alliages d'Al-Ti-Si, des alliages d'Al-Zr-Si, des alliages d'Al-Ti, et des alliages d'Al-Zr.

16. Procédé selon l'une quelconque des revendications 9 à 15, caractérisé en ce qu'il comprend, en outre, l'étape de soumission d'une surface de ladite quatrième couche (37) à l'implantation ionique d'au moins une impureté choisie dans le groupe constitué de l'As, du BF₂ et de l'Ar, de sorte que la surface de ladite quatrième couche (37) devienne amorphe.

17. Procédé selon la revendication 9, caractérisé en ce qu'il comprend, en outre, l'étape de recuit de ladite deuxième couche (34) dans une atmosphère d'azote.
